# EUROPEAN PATENT APPLICATION

(11) **EP 1 622 415 A1**
(43) Date of publication of application: **01.02.2006**
(21) Application number: 03715771.6
(22) Date of filing: 07.04.2003
(51) Int. Cl.: H04R 1/06, G06F 1/16, G06F 3/16

(54) **ELECTRONIC APPARATUS AND AUDIO SIGNAL OUTPUTTING METHOD OF ELECTRONIC APPARATUS**

(71) Applicant: KABUSHIKI KAISHA TOSHIBA, Minato-ku, Tokyo 105-8001 (JP)
(72) Inventor: KOKUBO, Shinji, B-644, Kureare-Toshiba-Ome, Ome-shi, Tokyo 198-0024 (JP)
(74) Representative: Henkel, Feiler & Hänzel
(86) International application number: PCT/JP2003/004401
(87) International publication number: WO 2004/091251

(57) **Abstract**

An electronic device of the present invention comprises a main body, a loudspeaker unit detachably connected to the main body and comprises a first wireless communication unit, a second wireless communication unit which makes wireless communication with the first wireless communication unit, an installation detector which detects whether the loudspeaker unit is installed in the main body or not, and a communication controller which transmits an audio signal to the loudspeaker unit through the second wireless communication unit when the installation detector detects that the loudspeaker unit is not installed in the main body.

## Description

### Technical Field

The present invention relates to an electronic device comprising a loudspeaker and an audio signal output method for the electronic device.

### Background Art

A notebook computer (hereinafter, referred to as notebook PC) comprises a loudspeaker for alarm output and audio output.

Usually, the loudspeaker is fixed to a casing of the notebook PC. Accordingly, the direction of the sound delivered from the loudspeaker is fixed, and the position of the loudspeaker is restricted.

Recently, notebook PCs are smaller and thinner, and therefore more difficult to install a loudspeaker therein.

Further, in a smaller and thinner notebook PC, since the installation state of the loudspeaker is restricted, it is hard to obtain good sound directivity and acoustic effects.

### Disclosure of Invention

It is hence an object of the present invention to provide an electronic device increased in the degree of freedom of position of loudspeaker, capable of selecting the sound output direction freely, and enhanced in the acoustic effect, and an audio signal output method of the electronic device.

The electronic device of the present invention comprises a main body, a loudspeaker unit detachably connected to the main body and comprises a first wireless communication unit, a second wireless communication unit which makes wireless communication with the first wireless communication unit, an installation detector detects whether the loudspeaker unit is installed in the main body or not, and a communication controller which transmits an audio signal to the loudspeaker unit through the second wireless communication unit when the installation detector detects that the loudspeaker unit is not installed in the main body.

The audio signal output method for an electronic device of the present invention comprises detecting whether a loudspeaker unit which is detachably installed in a main body and has a first wireless communication unit is installed in the main body or not, and transmitting an audio signal to the loudspeaker unit through a second wireless communication unit capable of making wireless communication with the first wireless communication unit when it is detected that the loudspeaker unit is not installed in the main body.

### Brief Description of Drawings

FIG. 1 is a perspective view showing an example of the structure of a notebook PC according to a first embodiment of the present invention;
FIG. 2 is a block diagram showing an example of hardware of the notebook PC according to the embodiment;
FIG. 3 is a flowchart showing an example of an audio signal output operation of a main body according to the embodiment;
FIG. 4 is a flowchart showing an example of a power supply operation from the main body to a loudspeaker unit according to the embodiment;
FIG. 5 is a flowchart showing an example of an audio signal output operation of the loudspeaker unit according to the embodiment;
FIG. 6 is a flowchart showing an example of a power supply operation in the loudspeaker unit according to the embodiment; and
FIG. 7 is a horizontal sectional view showing an example of a mounting state of the loudspeaker unit on the main body according to the embodiment.

### Best Mode for Carrying Out the Invention

Hereinafter, referring now to the drawings, embodiments of the present invention will be described. In the drawings, the same reference numerals are given to identical parts and duplicate explanation will be omitted.

In the embodiments below, the electronic device is explained using a notebook personal computer. The electronic device may also be a desktop computer, portable game machine, personal digital assistant (PDA), audio device, and the like.

### (First embodiment)

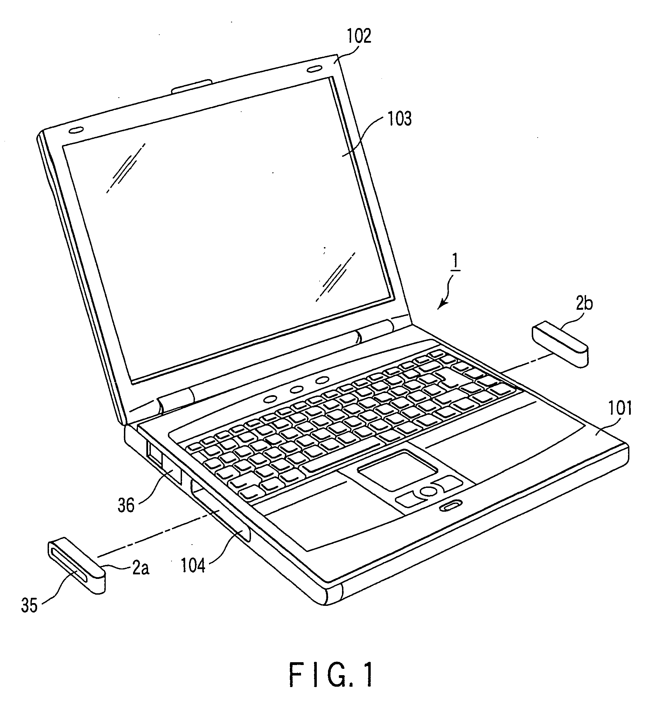

FIG. 1 is a perspective view showing an example of the structure of a notebook PC according to the embodiment.

The notebook PC 1 of the embodiment comprises a main body 101 and a display unit 102. The display unit 102 incorporates a display device 103 using a LCD. The display unit 102 incorporating the display device 103 is connected to the main body 101 rotatably between an open position and a closed position.

Detachable loudspeaker units 2a, 2b are installed in the main body 101 of the notebook PC 1.

At the right side and left side of the main body 101, there are compartments 104 for accommodating the loudspeaker units 2a, 2b. The loudspeaker units 2a, 2b output stereophonic sound from loudspeakers 35.

The loudspeaker units 2a, 2b are detached from the main body 101 by manipulating a slider 36 formed in the main body 101. The user can take out the loudspeaker units 2a, 2b from the main body 101 by sliding the slider 36 of the main body 101. The notebook PC 1 can be also used without detaching the loudspeaker units 2a, 2b from the main body 101.

When the loudspeaker units 2a, 2b are detached from the main body 101, an audio signal is wirelessly transmitted from the main body 101 to the loudspeaker units 2a, 2b.

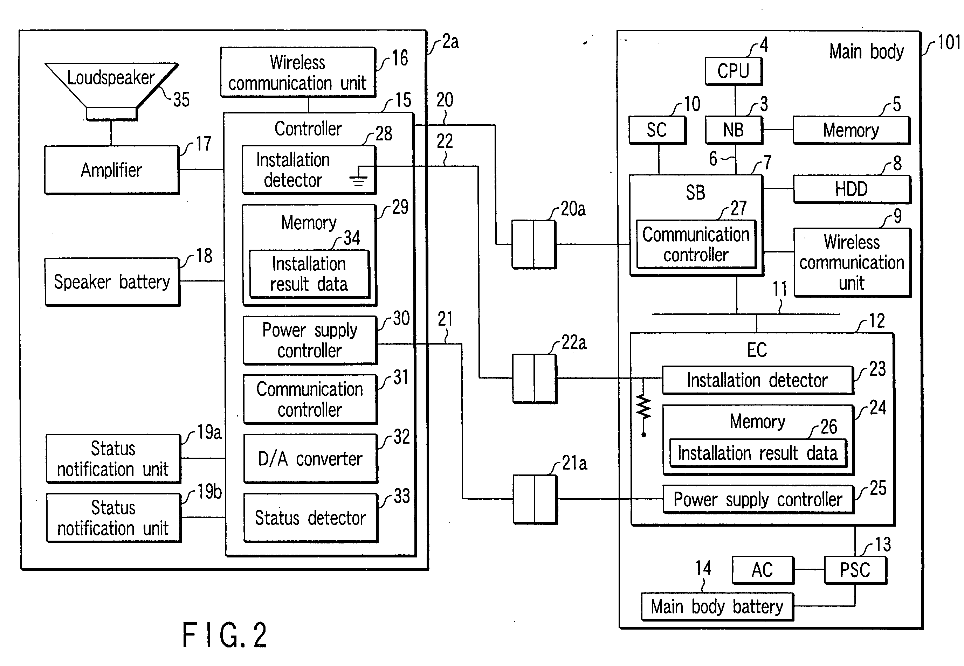

FIG. 2 is a block diagram showing an example of hardware of the notebook PC 1 according to the embodiment. In FIG. 2, the connection between the main body 101 and one loudspeaker unit 2a is shown, but the connection is also the same between the main body 101 and other loudspeaker unit 2b.

In the main body 101, a north bridge (NB) 3 is connected to a central processing unit (CPU) 4, a memory 5, and a PCI bus 6.

A south bridge (SB) 7 is connected to a PCI bus 6, a hard disk drive (HDD) 8, a wireless communication unit 9, a sound controller (SC) 10, and a low pin count (LPC) bus 11.

An embedded controller 12 is connected to the LPC bus 11 and a power supply controller 13.

The power supply controller 13, when receiving supply of electric power from an alternating-current power source (commercial power source), comprises functions of supplying the electric power from the alternating-current power source to each device in the main body 101, and also charging a main body battery 14.

On the other hand, the power supply controller 13, when not receiving supply of electric power from the alternating-current power source, supplies the electric power from the main body battery 15 to each device in the main body 101.

In the embodiment, a controller 15 of the loudspeaker unit 2a is connected to a wireless communication unit 16, an amplifier 17, a speaker battery 18, and status notification units 19a, 19b containing LED, etc.

When the loudspeaker unit 2a is installed in the main body 101, the controller 15 is connected to the south bridge 7 by way of an audio signal circuit 20 comprising a connector 20a.

When the loudspeaker unit 2a is installed in the main body 101, the controller 15 is connected to the embedded controller 12 by way of a power supply circuit 21 comprising a connector 21a and an installation detection circuit 22 comprising a connector 22a.

That is, when the loudspeaker unit 2a is detached from the main body 101, the connectors 20a, 21a, 22a are disconnected, and the audio signal circuit 20, power supply circuit 21, and installation detection circuit 22 are disconnected.

On the other hand, when the loudspeaker unit 2a is installed in the main body 101, the connectors 20a, 21a, 22a are connected, and the audio signal circuit 20, power supply circuit 21, and installation detection circuit 22 are connected.

The embedded controller 12 comprises an installation detector 23 to detect whether the loudspeaker unit 2a is installed in the main body 101 or not, a memory 24 for recording the result of installation detection, and a power supply controller 25 for controlling power supply to the loudspeaker unit 2a.

For example, the installation detector 23 provides specified power to the controller 15 by way of the installation detection circuit 22. The end of the controller 15 near the installation detection circuit 22 is grounded.

The installation detector 23 detects whether the loudspeaker unit 2a is detached or not by detecting whether the installation detection circuit 22 is grounded or not, and records detection result data 26 showing the result of detection in the memory 24. The memory 24 comprises, for example, a register.

The power supply controller 25 provides the electric power to the controller 15 by way of the power supply circuit 21 when the installation result data 26 recorded in the memory 24 indicates installation.

The power supply controller 25 also stops power supply to the loudspeaker unit 2a, when the main body 101 is operated by the electric power from the main body battery 14, in order to stop power consumption of the main body battery 14.

The south bridge 7 comprises a communication controller 27 for switching the output mode of an audio signal.

The communication controller 27 transmits the audio signal from the sound controller 10 to the controller 15 by way of the audio signal circuit 20 when the installation result data 26 in the memory 24 indicates installation.

On the other hand, when the installation result data 26 does not show installation, the communication controller 27 outputs the audio signal from the sound controller 10 by using the wireless communication unit 9. Between the wireless communication unit 9 and wireless communication unit 16, communication is established by, for example, Bluetooth (registered trademark).

The controller 15 of the loudspeaker unit 2a comprises an installation detector 28, a memory 29, a power supply controller 30, a communication controller 31, a D/A converter 32, and a status detector 33. The installation detector 28 is the same as the installation detector 23 of the main body 1, and its explanation will be omitted. Installation result data 34 showing the detection result by the installation detector 28 is recorded in the memory 29.

The power supply controller 30 supplies the electric power from the speaker battery 18 to each device in the loudspeaker unit 2a when the installation result data 34 of the memory 29 does not show installation.

On the other hand, the power supply controller 30 supplies the electric power from the power supply circuit 21 to each device in the loudspeaker unit 2a and charges the speaker battery 18 when the installation result data 34 shows installation.

The communication controller 31 sends the audio signal received from the audio signal circuit 20 to the D/A converter 32 when the installation result data 34 shows installation.

On the other hand, the communication controller 31 sends the audio signal received from the wireless communication unit 16 to the D/A converter 32 when the installation result data 34 does not show installation.

The D/A converter 32 converts the received audio signal from analog to digital data, and sends the data to the amplifier 17. The audio signal is amplified by the amplifier 17, and the sound is delivered from the loudspeaker 35.

The status detector 33 outputs the remaining power and charged state of the speaker battery 18, radio wave sensitivity of wireless communication, and others by using status notification units 19a, 19b. The status notification units 19a, 19b comprise, for example, LED capable of emitting light in green and orange colors. The status detector 33 lights the LED of the status notice unit 19a in green when the radio wave sensitivity of wireless communication is better than a specified sensitivity, and lights the LED in orange when the radio wave sensitivity is worse than the specified sensitivity. Further, depending on the radio wave sensitivity of wireless communication, the status detector 33 can change the LED from orange lighting to blinking.

Further, when the remaining power of the speaker battery becomes lower than a specified level (for example, below 30%), the status detector 33 lights the LED of the status notification unit 19b in orange, and depending on the decline of remaining power (for example, below 15%), switches the LED from lighting in orange to blinking. Still further, when the remaining power of the speaker battery 18 becomes lower than a specified level (for example, below 2%), the status detector 33 executes a process for delivering a warning sound from the loudspeaker 35.

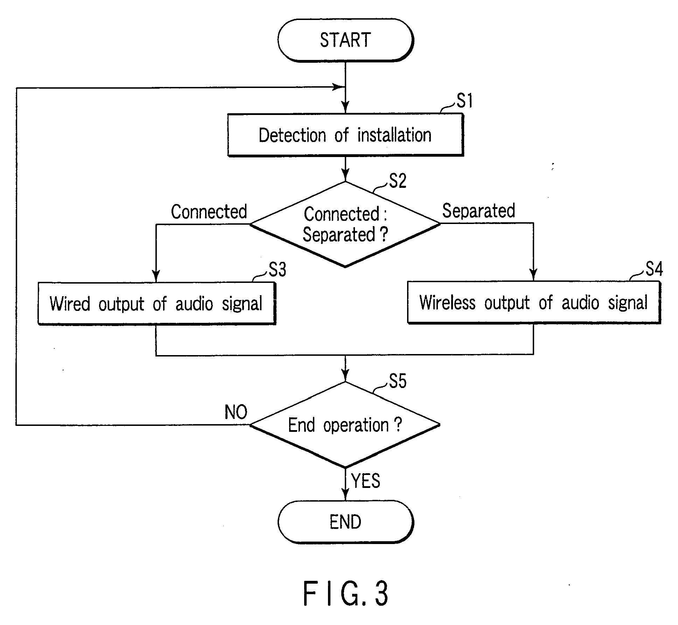

FIG. 3 is a flowchart showing an example of an audio signal output operation of the main body 101.

In step S1, the installation detector 23 records installation result data 26 showing the result of detection of installation of the loudspeaker unit 2a.

In step S2, the communication controller 27 determines whether the installation result data 26 shows installation or not.

When the installation result data 26 shows installation, in step S3, the communication controller 27 sends an audio signal to the controller 15 by way of the audio signal circuit 20.

On the other hand, when the installation result data 26 does not show installation, in step S4, the communication controller 27 outputs an audio signal by using the wireless communication unit 9.

In step S5, the main body 101 repeats this process until the operation has finished.

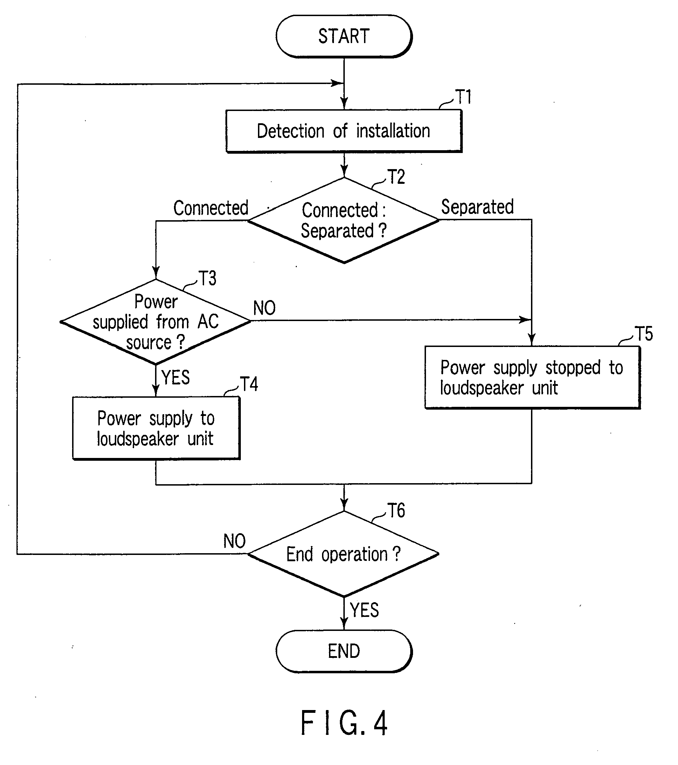

FIG. 4 is a flowchart showing an example of a power supply operation from the main body 101 to the loudspeaker unit 2a.

In step T1, the installation detector 23 records installation result data 26 showing the result of detection of installation of the loudspeaker unit 2a.

In step T2, the power supply controller 25 determines whether the installation result data 26 shows installation or not.

When the installation result data 26 shows installation, in step T3, the power supply controller 25 determines whether the main body 101 is operated by the electric power from the alternating-current power source or not.

When the main body 101 is operated by the electric power from the alternating-current power source, in step T4, the power supply controller 25 supplies the power from the alternating-current power source to the loudspeaker unit 2a by way of the power supply circuit 21.

On the other hand, when the installation result data 26 does not show installation, or when the main body 101 is operated by the electric power from the main body battery 14, in step T5, the power supply controller 25 stops power supply to the loudspeaker unit 2a.

In step T6, the main body 101 repeats this process until the operation has finished.

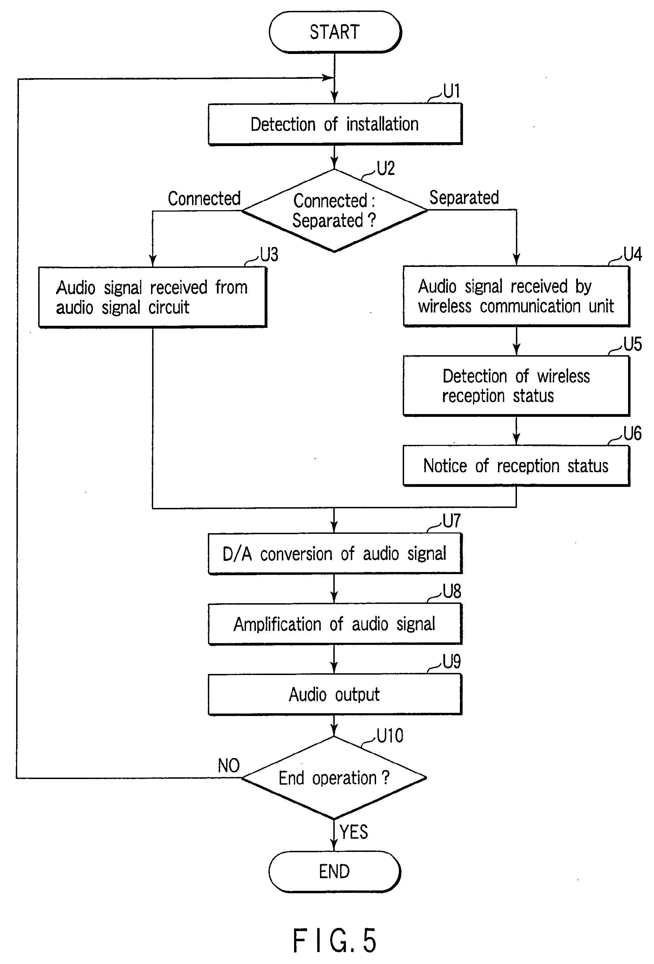

FIG. 5 is a flowchart showing an example of an audio signal output operation of the loudspeaker unit 2a.

In step U1, the installation detector 28 records installation result data 34 showing the result of detection of installation of the loudspeaker unit 2a.

In step U2, the communication controller 31 of the loudspeaker unit 2a determines whether the installation result data 34 shows installation or not.

When the installation result data 34 shows installation, in step U3, the communication controller 31 sends the audio signal received through the audio signal circuit 20 to the D/A converter 32.

On the other hand, when the installation result data 34 does not show installation, in step U4, the communication controller 31 sends the audio signal received through the wireless communication unit 16 to the D/A converter 32.

In step U5, the status detector 33 detects the reception status of the wireless communication unit 16.

In step U6, the status notification unit 19a or the loudspeaker 35 notices corresponding to the status detected by the status detector 33.

In step U7, the D/A converter 32 converts the audio signal from digital to analog data, and sends it to the amplifier 17.

In step U8, the amplifier 17 amplifies the audio signal and sends it to the loudspeaker 35.

In step U9, the loudspeaker 35 outputs sound according to the audio signal.

In step U10, the loudspeaker unit 2a repeats this process until the operation has finished.

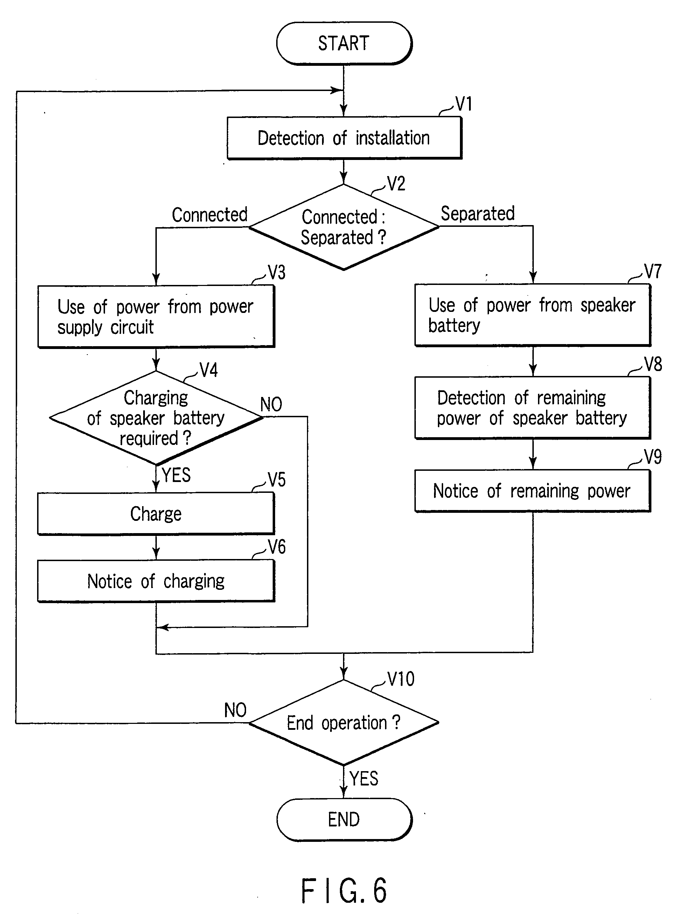

FIG. 6 is a flowchart showing an example of a power supply operation in the loudspeaker unit 2a.

In step V1, the installation detector 28 records installation result data 34 showing the result of detection of installation of the loudspeaker unit 2a.

In step V2, the power supply controller 30 of the loudspeaker unit 2a determines whether the installation result data 34 shows installation or not.

When the installation result data 34 shows installation, in step V3, the power supply controller 30 provides the electric power supplied from the power supply circuit 21 to each device.

In step V4, the power supply controller 30 determines if charging is necessary or not in the speaker battery 18.

If charging is necessary, in step V5, the power supply controller 30 charges the speaker battery 18 by the electric power supplied from the power supply circuit 21.

In step V6, the status detector 33 notices the charging process of the speaker battery 18 by using the status notification unit 19b.

On the other hand, when the installation result data 34 does not show installation, in step V7, the power supply controller 30 provides the electric power supplied from the speaker battery 18 to each device in the loudspeaker unit 2a.

In step V8, the status detector 33 detects a remaining power state of the speaker battery 18.

In step V9, the status detector 33 notices the detected state by using the status notification unit 19b or the loudspeaker 35.

In step V10, the loudspeaker unit 2a repeats this process until the operation has finished.

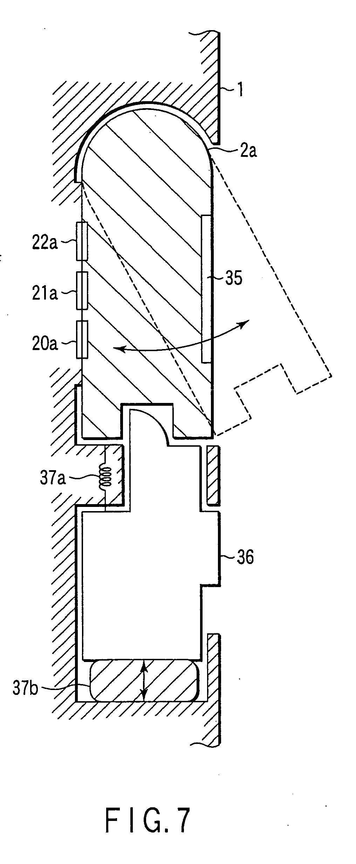

FIG. 7 is a horizontal sectional view showing an example of mounting state of the loudspeaker unit 2a on the main body 101.

The shape of the loudspeaker unit 2a is like an approximately rectangular solid. One end of the loudspeaker unit 2a is a curved surface and another end is a concave surface.

The shape of the accommodation space of the compartment 104 in the main body 101 is an approximately rectangular solid conforming to the loudspeaker unit 2a. One end of the accommodation space is a shape conforming to the curved surface of the loudspeaker unit 2a.

At another end of the accommodation space of the compartment 104, there is a slider 36 comprising a convex part. Elastic members 37a, 37b such as spring or rubber shift the slider 36 to the accommodation space side so that the convex part may project to the accommodation space in ordinary state. The slider 36 moves in the reverse direction of the accommodation space when putting the loudspeaker unit 2a into the compartment 104 or taking out the loudspeaker unit 2a from the compartment 104.

When accommodating the loudspeaker unit 2a, first, the user inserts one end of the loudspeaker unit 2a into the accommodation space. As a result, one end of the loudspeaker unit 2a is opposite to one end of the accommodation space.

Next, the user inserts another end of the loudspeaker unit 2a into the accommodation space. As a result, the convex part of the slider 36 and the curved surface of the loudspeaker unit 2a are engaged with each other.

When the loudspeaker unit 2a is completely inserted into the accommodation space of the compartment 104, the connectors 20a, 21a, 22a are set in a connected state.

When taking out the loudspeaker unit 2a, the user slides the slider 36 in a reverse direction of the accommodation space, and takes out the loudspeaker unit 2a from the compartment 104.

In the embodiment described above, the loudspeaker units 2a, 2b can be taken out from the main body 101 of the notebook PC 1. Accordingly, the user can dispose the loudspeaker units 2a, 2b at arbitrary positions, and can select the direction of the sound as desired, so that a favorable acoustic effect is achieved.
Thus, even if the notebook PC 1 is reduced in size or thickness, the user can achieve a favorable acoustic effect.

In this embodiment, when the loudspeaker units 2a, 2b are accommodated in the compartment 104, the loudspeaker unit 2a is fixed. Hence, it is not hard to carry the notebook PC 1.

Also in the embodiment, the power supply state of the loudspeaker units 2a, 2b, and the communication state between the main body 101 and loudspeaker units 2a, 2b are detected and noticed to the user. Accordingly, the user easily knows the state of the loudspeaker units 2a, 2b.

Also in the embodiment, when the loudspeaker units 2a, 2b are detached from the main body 101, audio signals are transmitted to the loudspeaker units 2a, 2b from the main body 101 by digital communication, so that audio signals can be transmitted and received favorably.

### (Second embodiment)

This embodiment is a modified example of the first embodiment.

Various techniques can be applied in detection of attachment and detachment of the loudspeaker units 2a, 2b. For example, when the loudspeaker units 2a, 2b are installed in the main body 101, a circuit is connected physically between the loudspeaker units 2a, 2b and the main body 101, and when the loudspeaker units 2a, 2b are detached from the main body 101, the circuit is disconnected, and through such circuit, the installation detectors 23, 28 transmit and receive a call signal and response signal between the loudspeaker units 2a, 2b and the main body 101. When the call signal and response signal cannot be transmitted or received, the installation detectors 23, 28 determine that the loudspeaker units 2a, 2b are detached from the main body 101.

The installation detector 23 or power supply controller 25 of the main body 101 may be realized also by the operation of, for example, the CPU 4 or south bridge 7, instead of the embedded controller 12.

Instead of the memory 24, the memory 5 or hard disk 8 may be used.

The communication controller 27 of the main body 101 may be realised also by the operation of, for example, the embedded controller 12 or CPU 4, instead of the south bridge 7.

The operation of the installation detector 23, power supply controller 24 or communication controller 27 of the main body 101 may be controlled by the utility program executed by the CPU. The utility program may display the remaining power of the speaker battery 18, the wireless communication state or attachment state between the main body 101 and the loudspeaker units 2a, 2b by a display device 103 installed in the main body 101.

The main body 101 may be configured to hold the loudspeaker units 2a, 2b when the loudspeaker units 2a, 2b are pushed into the compartment 104, and releasing the loudspeaker units 2a, 2b when the held loudspeaker units 2a, 2b are further pushed in.

The distance between the main body 101 and the loudspeaker units 2a, 2b may be detected by various methods, such as availability of wireless communications, and when it is determined that the distance exceeds a specified range, the loudspeaker units 2a, 2b may sound a warning alert. As a result, loss of the loudspeaker units 2a, 2b can be prevented.

## Claims

1. An electronic device **characterized by** comprising:
a main body;
a loudspeaker unit detachably connected to the main body and comprises a first wireless communication unit;
a second wireless communication unit which makes wireless communication with the first wireless communication unit;
an installation detector which detects whether the loudspeaker unit is installed in the main body or not; and
a communication controller which transmits an audio signal to the loudspeaker unit through the second wireless communication unit when the installation detector detects that the loudspeaker unit is not installed in the main body.

2. The electronic device according to claim 1,
**characterized in that** the main body comprises a connector to be electrically connected to the loudspeaker unit, and
the communication controller transmits an audio signal to the loudspeaker unit by way of the connector when the installation detector detects that the loudspeaker unit is installed in the main body.

3. The electronic device according to claim 1,
**characterized in that** the loudspeaker unit comprises:
a speaker installation detector which detects whether the loudspeaker unit is installed in the main body or not;
a battery which supplies electric power to devices in the loudspeaker unit; and
a power supply controller which supplies electric power from the battery to the first wireless communication unit when the speaker installation detector detects that the loudspeaker unit is not installed in the main body.

4. The electronic device according to claim 3,
**characterized in that** the power supply controller stops power supply to the first wireless communication unit when the speaker installation detector detects that the loudspeaker unit is installed in the main body.

5. The electronic device according to claim 3,
**characterized in that** the power supply controller charges the battery by the electric power supplied from the main body when the speaker installation detector detects that the loudspeaker unit is installed in the main body.

6. The electronic device according to claim 1,
**characterized in that** the loudspeaker unit comprises:
a status detector which detects the communication status of wireless communications of the first wireless communication unit; and
a status notification unit which notifies of the communication status detected by the status detector.

7. The electronic device according to claim 1,
**characterized in that** the main body comprises:
a power supply controller which detects whether power is supplied from a commercial power source or not, and supplies electric power to the loudspeaker unit according to the power supply received from the commercial power source when the power is supplied from the commercial power source and the installation detector detects that the loudspeaker unit is installed in the main body.

8. The electronic device according to claim 3,
**characterized in that** the loudspeaker unit comprises:
a status detector which detects the remaining power of the battery, and
a status notification unit which notifies of the remaining power of the battery detected by the status detector.

9. An audio signal output method for an electronic device **characterized by** comprising:
detecting whether the loudspeaker unit which is detachably installed in the main body and has a first wireless communication unit is installed in a main body or not, and
transmitting an audio signal to the loudspeaker unit through a second wireless communication unit capable of wireless communication with the first wireless communication unit when it is detected that the loudspeaker unit is not installed in the main body.

10. The audio signal output method according to claim 9, **characterized by** further comprising
transmitting an audio signal to the loudspeaker unit by way of a connector to be electrically connected to the loudspeaker unit when it is detected that the loudspeaker unit is installed in the main body.

11. The audio signal output method according to claim 9, **characterized by** further comprising
supplying an electric power to the first wireless communication unit from a battery of the loudspeaker unit when it is detected that the loudspeaker unit is not installed in the main body.

12. The audio signal output method according to claim 11, **characterized by** further comprising
stopping power supply to the first wireless communication unit from the battery when it is detected that the loudspeaker is installed in the main body.

13. The audio signal output method according to claim 11, **characterized by** further comprising
charging the battery with the electric power supplied from the main body by the loudspeaker when it is detected that the loudspeaker unit is installed in the main body.

14. The audio signal output method according to claim 9,
**characterized in that** the loudspeaker unit detects the communication status of wireless communications of the first wireless communication unit, and notifies the detected communication status.

15. The audio signal output method according to claim 9,
**characterized in that** the main body detects whether power is supplied from a commercial power source or not, and supplies electric power to the loudspeaker unit according to the power supply received from the commercial power source when the power is supplied from the commercial power source and the installation detector detects that the loudspeaker unit is installed in the main body.
